Europäisches Patentamt

European Patent Office

Office européen des brevets

(11) Publication number: **0 147 117**
**B1**

(12) **EUROPEAN PATENT SPECIFICATION**

(45) Date of publication of patent specification: **28.06.89**

(51) Int. Cl.⁴: **H 03 M 1/12**

(21) Application number: **84308547.3**

(22) Date of filing: **07.12.84**

(54) **Multiple input signal analog-digital converter circuitry.**

(30) Priority: **08.12.83 JP 232119/83**

(43) Date of publication of application:
**03.07.85 Bulletin 85/27**

(45) Publication of the grant of the patent:
**28.06.89 Bulletin 89/26**

(84) Designated Contracting States:
**DE FR GB IT**

(56) References cited:
**EP-A-0 006 779**
**US-A-3 597 761**
**US-A-3 732 376**

(73) Proprietor: **KABUSHIKI KAISHA ISHIDA KOKI SEISAKUSHO**
**44, Shogoin Sannou-cho Sakyo-ku**
**Kyoto-shi Kyoto 606 (JP)**

(72) Inventor: **Naito, Kazufumi**
**Haitsu-Nishiohtsu 302 4-5, Yanagasaki**
**Ohtsu-shi Shiga (JP)**

(74) Representative: **Fane, Christopher Robin King et al**
**HASELTINE LAKE & CO. Hazlitt House 28**
**Southampton Buildings Chancery Lane**
**London, WC2A 1AT (GB)**

**EP 0 147 117 B1**

Courier Press, Leamington Spa, England.

## Description

This invention relates to multiple input signal analog-digital converter circuitry for converting a number of analog signals into digital signals.

Multiple input signal analog-digital converter circuitry finds use in devices such as a combinatorial weighing apparatus.

A combinatorial weighing apparatus operates by supplying a plurality of weighing machines with articles to be weighed, computing combinations based on weight values obtained from the weighing machines, selecting a combination giving a total combined weight value equal or closest to a target weight, and discharging the articles solely from those weighing machines corresponding to the selected combination, thereby providing a batch of weighed articles of a weight equal or closest to the target weight.

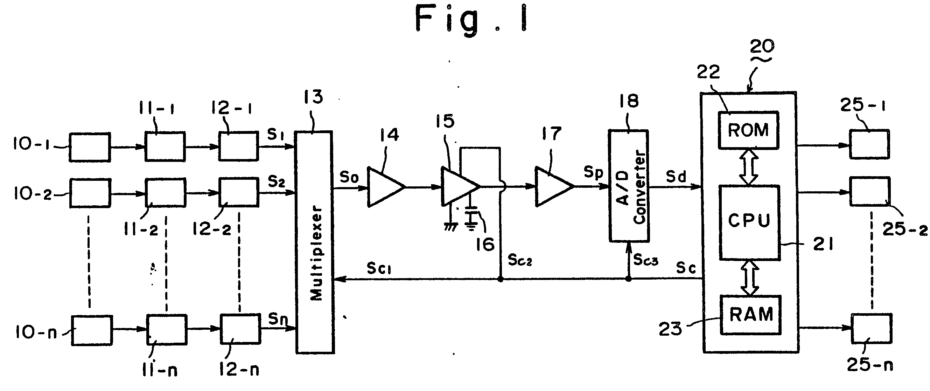

Such a combinatorial weighing apparatus will now be described in brief with reference to Figure 1 of the accompanying drawings. The apparatus includes load cells $10_{-1}$, $10_{-2}$...$10_{-n}$ for sensing the weight of articles introduced into the respective weighing hoppers belonging to n weighing machines. Each load cell produces a weight signal, namely an analog value indicative of the weight sensed thereby. The weight signals from these load cells $10_{-1}$, $10_{-2}$ ... $10_{-n}$ are applied as multiple input signals $S_1$, $S_2$ ... $S_n$ to a multiplexer 13 via amplifier circuits $11_{-1}$, $11_{-2}$ ... $11_{-n}$ and filters $12_{-1}$, $12_{-2}$ ... $12_{-n}$, respectively. The multiplexer 13, which is composed of analog switches or the like, responds to a selection signal $S_{c1}$ from a computation controller, described below, by selectively applying the weight signals $S_1$, $S_2$ ... $S_n$ as a weight data signal $S_o$ to a buffer circuit 14 sequentially in a time series. The buffer circuit 14 delivers the weight data signal $S_o$ received from the multiplexer 13 to a sample/hold circuit 15 upon subjecting the signal to an impedance conversion. The sample/hold circuit 15 repeatedly samples and holds the weight data signal $S_o$ subjected to the impedance conversion by the buffer circuit 14 and delivers the weight data signal to a buffer circuit 17. The latter subjects the signal to an impedance conversion, producing an analog weight data signal $S_p$ which is delivered to an analog-digital converter (A/D converter) 18. The latter digitalizes the analog weight data signal $S_p$ to produce a digital output $S_d$ which is applied to a computation controller 20. The latter is composed of a microcomputer and includes a processor 21 for performing combinatorial processing, a read-only memory (ROM) 22 storing a processing program for combinatorial processing, and a random-access memory (RAM) 23 for storing the weight data as well as the results of processing performed by the processor 21. The computation controller 20 computes combinations on the basis of the weight data, selects a combination giving a total combined weight value equal or closest to a target weight, and delivers a drive signal to drive units $25_{-1}$, $25_{-2}$ ... $25_{-n}$ of respective weighing hoppers belonging to those weighing machines which correspond to the selected combination.

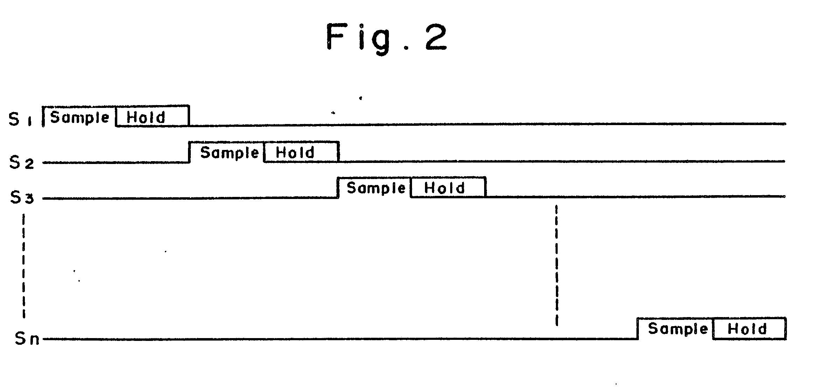

Thus, the multiple input signal A/D converter circuitry converts, into a digital value, the analog weight data signal $S_o$ delivered successively in a time series by the multiplexer 13. As shown in Figure 2, the A/D converter circuit successively samples and holds the weight data $S_1$, $S_2$, $S_3$ ... $S_n$ by means of the single sample/hold circuit 15 before delivering the data to the A/D converter 18. Unless the sample/hold circuit 15 operates at a sufficiently long sampling time, a capacitor 16 (Figure 1) for raising sampling precision cannot be charged. Accordingly, the A/D converter 18 is inoperative during sampling time, which is on the order of about 10 μsec. This means that the conventional multiple input signal A/D converter circuitry cannot make effective use of the A/D converter 18 despite the fact that the latter is capable of performing a conversion at high-speed.

It is accordingly desirable to provide multiple input signal high-speed analog-digital converter circuitry which is capable of subjecting a number of input signals to A/D conversion at high speed by making effective use of an A/D converter having a high-speed processing capability.

According to the present invention there is provided a combinatorial weighing apparatus in which a plurality of weight measuring devices is operable to weigh articles supplied thereto and to output respective analogue signals based on the measured weights, the apparatus including circuitry for processing the analogue signals to provide an output representing a selected combination of the measured weights equal or closest to a target weight, the circuitry comprising:

a multiplexer arranged to receive said analogue signals and to output a series of individual signals derived from said analogue signals;

and a sample/hold stage for sampling such individual signals and holding them during respective digitisation thereof by an analogue-to-digital converter of the circuitry,

characterised in that the sample/hold stage includes first and second sample/hold circuits, each for sampling such individual signals and holding them during respective digitisation thereof by the said analogue-to-digital converter, and means for rendering those circuits operative alternately, for respective alternate signals of the said series, so that during the period in which one of those circuits is holding one signal of the said series during digitisation thereof the other of those circuits is sampling the next signal of the series, whereby digitisation of successive signals of the series can be effected substantially without pauses between successive signals.

With such multiple input signal analogue-digital converter circuitry forming part of the invention, while one of the sample/hold circuits is holding an input signal, the other sample/hold circuit is sampling another input signal. Accordingly, the A/D conversion time of the multiplicity of input signals is capable of being shortened by the sampling time of the sample/hold circuits, so that effective use can be made of an A/D converter having a high-speed processing capability.

U.S. 3,597,761 describes an analogue-to-digital converter which has two comparator banks. An analogue signal to be digitised is passed firstly to one of the comparator banks, and a reference voltage is derived depending on the value of the signal. This reference voltage and the analogue signal itself are then passed to a second comparator bank. In one form, the analogue signal is fed via two sample/hold circuits. At a first instant in time, the signal is sampled by a first sample/hold circuit where it is held and from where it is supplied to the first comparator bank. While the reference voltage is being derived, the held signal is applied to the second comparator bank. While digitisation in the second comparator bank has been taking place, the first comparator bank is coupled to a second sample and hold circuit.

Hence, the converter is always in receipt of a held signal, either to its first or its second bank. The concept of two sample/hold circuits has been designed in particular association with this type of converter.

There is no indication in U.S. 3,597,761 that there is any more general application of two sample/hold circuits or that the converter described therein would have any particular advantage if applied to combinatorial weighing apparatus of the type described above.

For a better understanding of the invention, and to show how it may be carried into effect, reference will now be made, by way of example, to the accompanying drawings, in which:

Figure 1 is a block diagram illustrating a combinatorial weighing apparatus having multiple input signal analog-digital converter circuitry according to the prior art as described above;

Figure 2 is a timing chart indicating the operation of a sample/hold circuit of the multiple input signal analog-digital converter circuitry of Figure 1;

Figure 3 is a circuit diagram of multiple input signal high-speed analog-digital converter circuitry embodying the present invention; and

Figure 4 is a timing chart indicating the operation of sample/hold circuits in the arrangement of Figure 3.

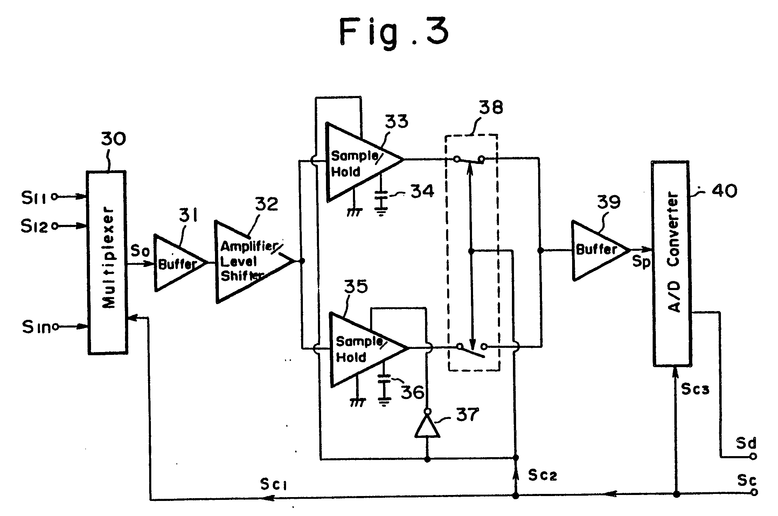

In Figure 3, weight data from load cells $10_{-1}$, $10_{-2} \ldots 10_{-n}$ of a plurality of weighing machines in a combinatorial weighing apparatus as described above with reference to Figure 1 are applied in parallel as multiple input signals $S_{11}$, $S_{12} \ldots S_{1n}$ to a multiplexer 30. The multiplexer 30 selectively applies the weight data as a weight data signal $S_o$ to a buffer circuit 31 sequentially in a time series. The buffer circuit 31 delivers the weight data signal $S_o$ received from the multiplexer 30 to an amplifier/level-shift circuit 32, subjecting the signal to an impedance conversion. The amplifier/level-shift circuit 32 delivers the weight data signal from the buffer circuit 31 after adjusting the mu-factor and zero level of the signal.

Numerals 33, 35 denote first and second sample/hold circuits, respectively, both of which receive the output signal $S_o$ of the multiplexer 30 via the buffer circuit 31 and amplifier/level-shift circuit 32 for repeating a sample-and-hold action. The first and second sample/hold circuits 33, 35 are equipped with capacitors 34, 36, respectively, for being charged when the weight data signal is sampled and for holding the charge when the signal is held.

A changeover switch 38 permits only one of the first and second sample/hold circuits 33, 35 to deliver an output at any time in such a manner that one of the sample/hold circuits is made to perform a holding operation while the other performs a sampling operation. The output of the changeover switch 38, namely a weight data signal from one of the sample/hold circuits 33, 35, is applied to a buffer circuit 39 which delivers the signal as a signal $S_p$ following an impedance conversion. An A/D converter 40 digitalizes the analog weight data signal $S_p$ to produce a digital output signal $S_d$ which is applied to, say, the computation controller 20 of Figure 1. The computation controller performs a digital computation based on the weight data signals $S_{11}, S_{12} \ldots S_{1n}$ received from the respective weighing machines to decide a combination closest to a target weight value.

To perform the foregoing operation, the computation controller produces a control signal $S_c$ and applies the signal synchronously to the multiplexer 30 as a selection signal $S_{c1}$; to the first and second sample/hold circuits 33, 35 and changeover switch 38 as a changeover command signal $S_{c2}$, and to the A/D converter 40 as a control signal $S_{c3}$. In response to the selection signal $S_{c1}$ applied to the multiplexer 30, signals from among the multiple input signals $S_{11}, S_{12} \ldots S_{1n}$ are selected for application to the sample/hold circuits 33, 35, which also receive the changeover command signal $S_{c2}$, with the second sample/hold circuit 35 receiving the signal via an inverter 37.

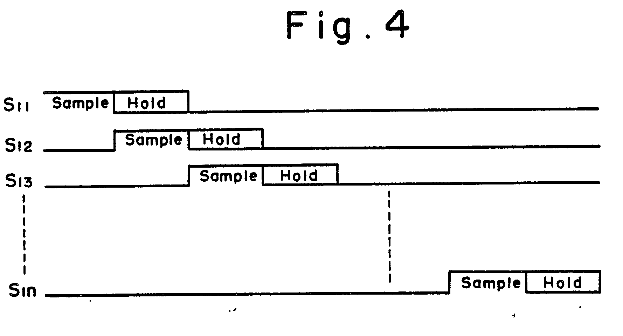

Accordingly, as shown in Figure 4, while one input signal is being held by the first sample/hold circuit 33 or second sample/hold circuit 35, the following input signal is being sampled by the other sample/hold circuit 35 or 33. Further, in response to the control signal $S_{c3}$ applied to the A/D converter 40, the A/D conversion ends. When this occurs, the holding of one input signal ends and the holding of the following input signal begins. In other words, A/D conversion now restarts and, at the same time, so does sampling of the next input signal. This operation is performed repeatedly so that digital computations are carried out while the A/D conversion continues at high speed without a pause. It goes without saying that the same method can be employed when an item of weight data from a single weighing machine is sampled a plurality of times followed by switching the multiplexer to sample weight data from the next weighing machine.

In the foregoing it will be appreciated that the multiplexer output signal $S_o$ as adjusted and applied to the sample/hold circuitry may be regarded as a series of individual input signals derived respectively from the original inputs $S_{11}$, $S_{12}$, ... $S_{1n}$ to the multiplexer 30.

## Claims

1. A combinatorial weighing apparatus in which a plurality of weight measuring devices ($10_{-1}$, $10_{-2}$ ... $10_{-n}$) are operable to weigh articles supplied thereto and to output respective analogue signals ($S_1$, $S_2$ ... $S_n$) based on the measured weights, the apparatus including circuitry for processing the analogue signals to provide an output representing a selected combination of the measured weights equal or closest to a target weight, the circuitry comprising:

a multiplexer (30) arranged to receive said analogue signals and to output a series (So) of individual signals derived from said analogue signals; and

a sample/hold stage (33 through 38) for sampling such individual signals and holding them during respective digitisation thereof by an analogue-to-digital converter (40) of the circuitry,

characterised in that the sample/hold stage includes first and second sample/hold circuits (33, 35), each for sampling such individual signals and holding them during respective digitisation thereof by the said analogue-to-digital converter (40), and means (37, 38) for rendering those circuits operative alternately, for respective alternate signals of the said series, so that during the period in which one of those circuits is holding one signal of the said series during digitisation thereof the other of those circuits is sampling the next signal of the series, whereby digitisation of successive signals of the series can be effected substantially without pauses between successive signals.

2. Apparatus as claimed in claim 1, in which the circuitry comprises a buffer circuit (31), operatively connected to said multiplexer, for performing impedance conversion on individual signals of the series.

3. Apparatus as claimed in claim 1 or 2, in which the circuitry comprises an amplifier/level shifter circuit (32) including an amplifier having an adjustable mu-factor, connected between said first buffer circuit and said first and second sample/hold circuits, for adjusting the mu-factor of the amplifier and the zero level of the individual signals of the series after said buffer circuit has performed impedance conversion on said signals, and for providing said individual signals to said first and second sample/hold circuits.

4. Apparatus as claimed in claim 2 or 3, in which the circuitry includes a second buffer circuit, connected between said means (37, 38) for rendering the sample/hold circuits alternately operative and said analogue-digital converter, for performing an impedance conversion on outputs of the first and second sample/hold circuits in accordance with the state of said means.

## Patentansprüche

1. Kombinatorische Wägvorrichtung, bei der mehrere Gewichtsmeßeinrichtungen ($10_{-1}$, $10_{-2}$, ... $10_{-n}$) so betreibbar sind, daß sie ihnen zugeführte Artikel wägen und auf den gemessenen Gewichten basierende jeweilige Analogsignale ($S_1$, $S_2$, ... $S_n$) ausgeben, wobei die Vorrichtung eine Schaltung zur Verarbeitung der Analogsignale enthält, die ein Ausgangssignal erzeugt, welches eine gewählte Kombination des gemessenen Gewichtes repräsentiert, die einem Zielgewicht gleicht oder am nächsten kommt, mit

einem Multiplexer (30), der so geschaltet ist, daß er die Analogsignale empfängt und eine Reihe (So) individueller, von den Analogsignalen abgeleiteter Signale ausgibt; und

einer Abtast- und Halte-Stufe (33 bis 38) zum Abtasten der individuellen Signale und zum Halten der Signale während der jeweiligen, durch einen Analog- und Digital-Wandler (40) der Schaltung erfolgenden Digitalisierung der Signale,

dadurch gekennzeichnet, daß die Abtast- und Halte-Stufe enthält: erste und zweite Abtast- und Halte-Schaltungen (33, 35), von denen jede zum Abtasten der individuellen Signale und zum Halten der Signale während der jeweiligen, durch den Analog- und Digital-Wandler (40) erfolgenden Digitalisierung der Signale dient, und Mittel (37, 38), die diese Schaltungen alternierend für jeweilige alternierende Signale der Reihe wirksam machen, so daß während der Phase, in der eine dieser Schaltungen ein Signal der Reihe während dessen Digitalisierung hält, die andere dieser Schaltungen das nächste Signal der Reihe abtastet, wodurch die Digitalisierung aufeinanderfolgender Signale der Reihe im wesentlichen ohne Pausen zwischen aufeinanderfolgenden Signalen durchführbar ist.

2. Vorrichtung nach Anspruch 1, bei der die Schaltung eine mit dem Multiplexer betriebsmäßig verbundene Pufferschaltung (31) zum Durchführen von Impedanzwandlung für individuelle Signale der Reihe aufweist.

3. Vorrichtung nach Anspruch 1 oder 2, bei der die Schaltung eine Verstärker/Pegel-Verschiebungsschaltung (32) aufweist, die einen Verstärker mit einstellbarem mu-Faktor aufweist und zwischen die erste Pufferschaltung und die ersten und zweiten Abtast- und Halte-Schaltungen geschaltet ist, zum Einstellen des mu-Faktors des Verstärkers und des Null-Pegels der individuellen Signale der Reihe, nachdem die Pufferschaltung die Impedanzwandlung für die Signale durchgeführt hat, und zum Zuführen der individuellen Signale zu den ersten und zweiten Abtast- und Halte-Schaltungen.

4. Vorrichtung nach Anspruch 2 oder 3, bei der die Schaltung eine zweite Pufferschaltung aufweist, die zwischen die Mittel (37, 38), die die Abtast- und Halte- Schaltungen alternierend wirksam machen, und den Analog- und Digital-Wandler geschaltet sind, zum Durchführen von Impedanzwandlung der Ausgangssignale der ersten und zweiten Abtast- und Halte-Schaltungen entsprechend dem Zustand der genannten Mittel.

**Revendications**

1. Appareil de pesage combinatoire dans lequel une pluralité de dispositifs de mesure de poids $(10_{-1}, 10_{-2}, \ldots 10_{-n})$ peuvent fonctionner pour peser des articles qui leur sont délivrés et pour sortir des signaux analogiques respectifs, $(S_1, S_2 \ldots S_n)$ basés sur les poids mesurés, l'appareil comprenant des circuits pour traiter les signaux analogiques de façon à fournir une sortie représentant une combinaison choisie de poids mesurés égaux ou les plus proches d'un poids cible, les circuits comportant:

un multiplexeur (30) disposé pour recevoir lesdits signaux analogiques et pour sortir une série (So) de signaux individuels tirés desdits signaux analogiques; et

un étage d'échantillonnage/maintien (de 33 à 38) pour échantillonner de tels signaux individuels et les maintenir pendant la numérisation respectife de ceux-ci par un convertisseur (40) analogique-numérique des circuits,

caractérisé par le fait que l'étage d'échantillonnage/maintien comprend un premier et un second circuits d'échantillonnage/maintien (33, 35), chacun pour l'échantillonnage de tels signaux individuels et leur maintien pendant la numérisation respectife de ceux-ci par ledit convertisseur analogique-numérique (40), et un moyen (37, 38) pour rendre ces circuits alternativement opérationnels, pour des signaux alternatifs respectifs de ladite série, de sorte qu'au cours de la période dans laquelle un de ces circuits maintient un signal de ladite série au cours de la numérisation de ceuxi-ci, l'autre de ces circuits échantillonne le signal suivant de la série, grâce à quoi la numérisation de signaux successifs de la série peut être effectuée essentiellement sans temps de repos entre les signaux successifs.

2. Appareil conforme à la revendication 1, dans lequel les circuits comprennent un circuit tampon (31), connecté de façon opérationnelle audit multiplexeur, pour accomplir une conversion d'impédance sur des signaux individuels de la série.

3. Appareil conforme à la revendication 1 ou 2, dans lequel les circuits comprennent un circuit (32) de décalage de niveau/amplificateur comportant un amplificateur ayant un facteur mu réglable, connecté entre ledit premier circuit tampon et lesdits premier et second circuits d'échantillonnage/maintien, pour régler le facteur mu de l'amplificateur et le niveau zéro des signaux individuels de la série après que ledit circuit tampon a accompli une conversion d'impédance sur lesdits signaux, et pour fournir lesdits signaux individuels auxdits premier et second circuits d'échantillonnage/maintien.

4. Appareil selon la revendication 2 ou 3, dans lequel les circuits comprennent un second circuit tampon, connecté entre lesdits moyens (37, 38) pour rendre les circuits d'échantillonnage/maintien alternativement opérationnels et ledit convertisseur analogique-numérique, pour réaliser une conversion d'impédance sur des sorties des premier et second circuits d'échantillonnage/maintien selon l'état desdits moyens.

# Fig. 1

EP 0 147 117 B1

# Fig. 2

# Fig.3

EP 0 147 117 B1

# Fig.4